# FASCICULE DE BREVET EUROPEEN

(11) **EP 3 667 335 B1**
(45) Date de publication et mention de la délivrance du brevet: **28.08.2024**
(21) Numéro de dépôt: 19212005.3
(22) Date de dépôt: 28.11.2019
(51) Int. Cl.: G01R 22/06, G01R 11/24, G01R 11/04

(54) **COMPTEUR ELECTRIQUE AYANT UN ACCES A LA CONNECTIQUE SITUE SUR LA FACE ARRIERE**
STROMZÄHLER, DER EINEN ZUGANG ZUM RÜCKSEITIGEN ANSCHLUSS BESITZT
ELECTRICITY METER WITH ACCESS TO THE CONNECTOR ON THE REAR SURFACE

(30) Priorité: 12.12.2018 FR 1872799
(43) Date de publication de la demande: 17.06.2020
(73) Titulaire: Sagemcom Energy & Telecom SAS, 92270 Bois-Colombes (FR)
(72) Inventeur: REGNAULT, Laurent, 92500 RUEIL MALMAISON (FR); ENGEL, Philippe, 92500 RUEIL MALMAISON (FR)
(74) Mandataire: Cabinet Boettcher

(56) Documents cités:
- DE-A1- 102004 004 234
- FR-A1- 3 013 521
- FR-A1- 3 054 322
- US-A- 1 916 219

## Description

L'invention concerne le domaine des compteurs électriques ayant un accès à la connectique situé sur une face arrière.

### ARRIERE PLAN DE L'INVENTION

Un compteur électrique permet de mesurer la consommation d'énergie électrique d'une installation électrique. L'énergie électrique est fournie à l'installation électrique par un réseau de distribution.

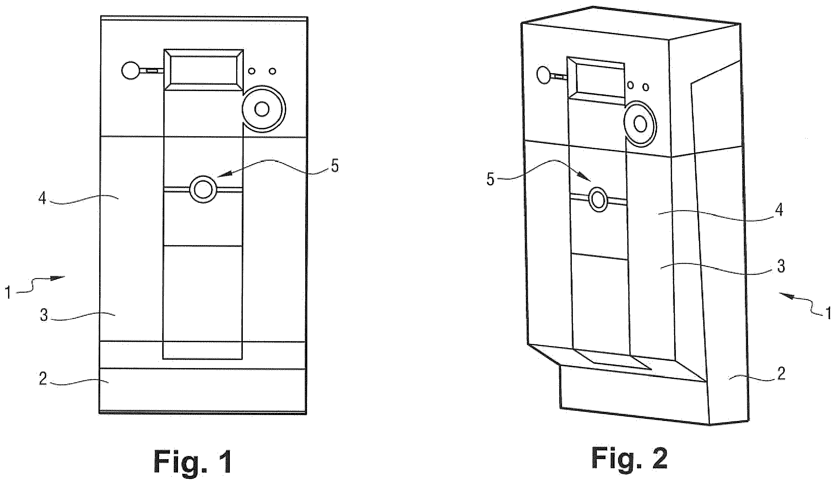

En référence aux figures 1 et 2, un compteur électrique de l'art antérieur 1 comporte ainsi classiquement un boîtier 2 raccordé à la fois à une ligne du réseau de distribution et à l'installation électrique, dans lequel sont intégrés des moyens de mesure de l'énergie électrique consommée (capteur(s) de courant, de tension, etc.). Le compteur électrique 1 comprend un couvre-bornes 3 positionné sur la face avant 4 du boîtier 2, qui est équipé d'un dispositif de scellement 5.

Les compteurs électriques modernes comportent souvent des composants additionnels permettant de mettre en œuvre de nouvelles fonctions. Parmi ces composants additionnels, on trouve classiquement un ou plusieurs organes de coupure pouvant être commandés à distance et permettant au distributeur d'interrompre la distribution de l'énergie électrique, dans le cas par exemple où le client déménage ou bien ne paie pas ses factures. On trouve aussi des moyens de communication filaires ou sans fil, destinés à transmettre et à recevoir diverses informations, par exemple des informations relatives à la consommation électrique de l'installation, à l'abonnement souscrit par le client, etc.

On sait qu'il existe un certain nombre de méthodes de fraude susceptibles d'être utilisées par des individus peu scrupuleux pour réduire leurs factures d'électricité.

Parmi ces méthodes de fraude, certaines consistent à court-circuiter ou à dériver une ou des phases de la ligne du réseau de distribution, qui apporte l'énergie électrique à l'installation.

FR 3 013 521 A1 divulgue un panneau apte à porter plusieurs types de compteurs électriques différents. Le panneau définit un support et la face arrière d'un compteur électrique est montée sur le panneau. Des fils conducteurs amont et aval sont amenés via le panneau sur la face arrière du compteur.

DE 10 2004 004234 A1, FR 3 054 322 A1 et US 1 916 219 A divulguent d'autres conceptions connues de compteurs électriques avec leurs connexions électriques respectives.

### OBJET DE L'INVENTION

L'invention a pour objet de réduire le risque de fraude sur un compteur électrique.

### RESUME DE L'INVENTION

En vue de la réalisation de ce but, on propose un compteur électrique agencé pour mesurer la consommation électrique d'une installation, le compteur électrique étant de plus agencé pour être connecté à au moins un couple de conducteurs comprenant un conducteur amont appartenant à un réseau de distribution et un conducteur aval appartenant à l'installation, le compteur électrique comportant :
- un boîtier agencé pour être fixé à un support vertical, le boîtier comprenant une face arrière destinée à être positionnée contre le support vertical ;
- des moyens de connexion intégrés à l'intérieur du boîtier et comprenant, pour chaque couple de conducteurs, un couple de moyens de connexion comprenant un moyen de connexion amont agencé pour être connecté au conducteur amont dudit couple de conducteurs, et un moyen de connexion aval agencé pour être connecté au conducteur aval dudit couple de conducteurs ;
- un accès amont permettant d'accéder, depuis l'extérieur du compteur électrique, aux moyens de connexion amont, l'accès amont étant situé sur la face arrière du boîtier,
le compteur électrique comprenant en outre un accès aval permettant d'accéder, depuis l'extérieur du compteur électrique, aux moyens de connexion aval, l'accès aval étant situé sur une face avant du compteur électrique.

L'accès amont, permettant d'accéder aux moyens de connexion amont reliés au réseau de distribution, est donc situé sur la face arrière du compteur électrique. Cette face arrière est positionnée contre le support vertical (qui est par exemple un mur) lorsque le compteur électrique est installé dans sa position normale de fonctionnement, de sorte que l'accès amont est inaccessible. On dissuade ainsi un individu potentiellement fraudeur de passer à l'acte.

On propose de plus un procédé d'installation sur un support vertical du compteur électrique qui vient d'être décrit, comportant les étapes de :
- Positionner le compteur électrique sur un support mobile, et approcher le support mobile du support vertical ;
- Connecter le ou les conducteurs amont du réseau de distribution aux moyens de connexion amont du compteur électrique ;
- Fixer le compteur électrique au support vertical ;
- Connecter le ou les conducteurs aval de l'installation aux moyens de connexion aval du compteur électrique.

On propose en outre un procédé d'installation sur un support vertical du compteur électrique qui vient d'être décrit, comportant les étapes de :
- Fixer le boîtier à une lame mobile d'une charnière dont la lame fixe est fixée au support vertical ;
- Orienter le compteur électrique de manière à éloigner la face arrière du support vertical ;
- Connecter le ou les conducteurs amont du réseau de distribution aux moyens de connexion amont du compteur électrique ;
- Connecter le ou les conducteurs aval de l'installation aux moyens de connexion aval du compteur électrique ;
- Positionner la face arrière du compteur électrique contre le support vertical.

L'invention sera mieux comprise à la lumière de la description qui suit de modes de mise en œuvre particuliers non limitatifs de l'invention.

### BREVE DESCRIPTION DES DESSINS

Il sera fait référence aux dessins annexés, parmi lesquels :
[Fig. 1] la figure 1 est une vue de face d'un compteur électrique de l'art antérieur ;
[Fig. 2] la figure 2 est une vue en perspective du compteur électrique de la figure 1 ;
[Fig. 3] la figure 3 est une vue en coupe, selon un premier plan transversal, du compteur électrique selon un premier mode de réalisation de l'invention ;
[Fig. 4] la figure 4 est une vue de face, partielle, du compteur électrique selon le premier mode de réalisation de l'invention, le couvre-bornes aval étant retiré ;
[Fig. 5] la figure 5 est une vue en coupe, selon le premier plan transversal, d'un compteur électrique selon un deuxième mode de réalisation de l'invention ;
[Fig. 6] la figure 6 est une vue en coupe, selon un deuxième plan transversal, du compteur électrique selon le deuxième mode de réalisation de l'invention ;
[Fig. 7] la figure 7 est une vue équivalente à celle de la figure 6, pour un compteur électrique de l'art antérieur ;
[Fig. 8a] la figure 8a illustre un premier procédé d'installation d'un compteur électrique selon l'invention ;
[Fig. 8b] la figure 8b illustre un premier procédé d'installation d'un compteur électrique selon l'invention ;
[Fig. 8c] la figure 8c illustre un premier procédé d'installation d'un compteur électrique selon l'invention ;
[Fig. 9a] la figure 9a illustre un deuxième procédé d'installation d'un compteur électrique selon l'invention ;
[Fig. 9b] la figure 9b illustre un deuxième procédé d'installation d'un compteur électrique selon l'invention ;
[Fig. 9c] la figure 9c illustre un deuxième procédé d'installation d'un compteur électrique selon l'invention ;
[Fig. 9d] la figure 9d illustre un deuxième procédé d'installation d'un compteur électrique selon l'invention.

### DESCRIPTION DETAILLEE DE L'INVENTION

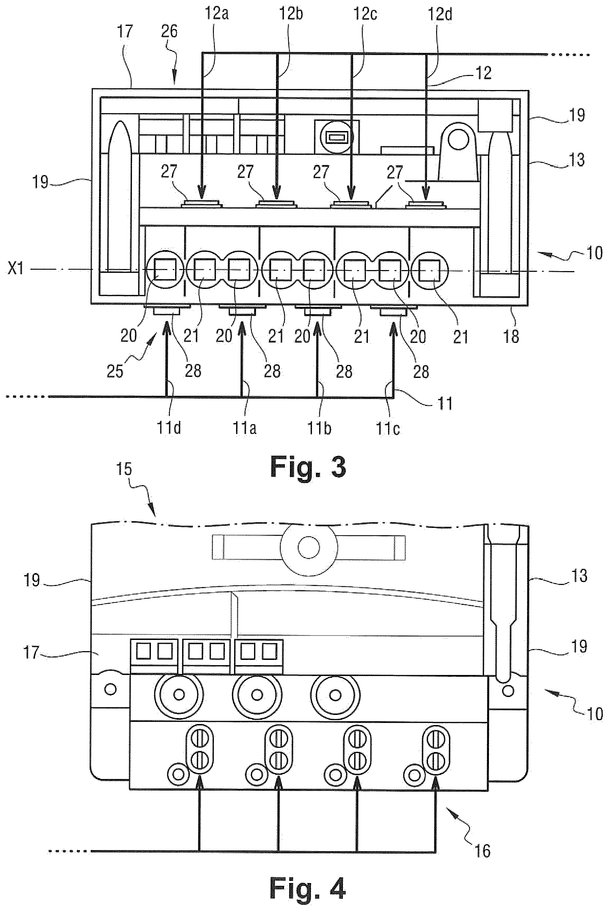

On décrit tout d'abord, en référence aux figures 3 et 4, un compteur électrique selon un premier mode de réalisation de l'invention 10.

Le compteur électrique 10 est destiné à mesurer la consommation électrique d'une installation qui est alimentée par une ligne triphasée d'un réseau de distribution.

La ligne triphasée comprend un premier conducteur de phase amont 11a, un deuxième conducteur de phase amont 11b, un troisième conducteur de phase amont 11c, et un conducteur de neutre amont 11d. Par « amont », on entend ici du côté du réseau de distribution, et par « aval », on entend ici du côté de l'installation. La ligne triphasée comprend donc quatre conducteurs amont 11 auxquels est connecté le compteur électrique 10.

Le compteur électrique 10 est aussi connecté à quatre conducteurs aval 12 de l'installation : un premier conducteur de phase aval 12a relié au premier conducteur de phase amont 11a via le compteur électrique 10, un deuxième conducteur de phase aval 12b relié au deuxième conducteur de phase amont 11b via le compteur électrique 10, un troisième conducteur de phase aval 12c relié au troisième conducteur de phase amont 11c via le compteur électrique 10, et un conducteur de neutre aval 12d.

Le compteur électrique 10 est donc connecté ici à quatre couples de conducteurs : un premier couple formé par le premier conducteur de phase amont 11a et le premier conducteur de phase aval 12a, un deuxième couple formé par le deuxième conducteur de phase amont 11b et le deuxième conducteur de phase aval 12b, un troisième couple formé par le troisième conducteur de phase amont 11c et le troisième conducteur de phase aval 12c, et un quatrième couple formé par le conducteur de neutre amont 11d et par le conducteur de neutre aval 12d.

Le compteur électrique 10 comporte un boîtier 13 à l'intérieur duquel sont intégrés notamment des moyens de mesure permettant de mesurer l'énergie électrique consommée par l'installation.

Le boîtier 13 comprend des moyens de fixation pour fixer le boîtier 13 au mur.

Le boîtier 13 comprend une face supérieure 15, une face inférieure 16, une face avant 17, une face arrière 18 et deux faces latérales 19. Ces termes doivent être interprétés en considérant la position du boîtier 13 lorsque le boîtier 13 est fixé au mur dans une position normale de fonctionnement. La face arrière 18 est ainsi destinée à être positionnée contre le mur, alors que la face avant 17 est visible et accessible directement depuis l'extérieur du compteur électrique 10.

On appelle ici hauteur la dimension du boîtier 13 entre la face supérieure 15 et la face inférieure 16 du boîtier 13, profondeur la dimension du boîtier 13 entre la face avant 17 et la face arrière 18, et largeur la dimension du boîtier 13 entre les faces latérales 19.

Le compteur électrique 10 comporte des moyens de connexion intégrés à l'intérieur du boîtier 13 et comprenant, pour chaque couple de conducteurs, un couple de moyens de connexion comprenant un moyen de connexion amont 20 agencé pour être connecté au conducteur amont 11 dudit couple de conducteurs, et un moyen de connexion aval 21 agencé pour être connecté au conducteur aval 12 dudit couple de conducteurs.

Le compteur électrique 10 comporte donc ici quatre couples de moyens de connexion comprenant en tout quatre moyens de connexion amont 20 et quatre moyens de connexion aval 21. Ici, chaque moyen de connexion 20, 21 comprend une cage à vis comportant une vis de serrage.

Le compteur électrique 10 comporte aussi un accès amont 25 permettant d'accéder, depuis l'extérieur du compteur électrique 10, aux moyens de connexion amont 20, et un accès aval 26 permettant d'accéder, depuis l'extérieur du compteur électrique 10, aux moyens de connexion aval 21.

L'accès amont 25 est situé sur la face arrière 18 du boîtier 13 du compteur électrique 10, c'est-à-dire sur la face du boîtier 13 destinée à être positionnée contre le mur.

L'accès amont 25 est ici protégé par un couvre-bornes amont positionné sur la face arrière 18 du boîtier 13 et équipé d'un dispositif de scellement.

L'accès aval 26 est situé sur la face avant 17 du boîtier 13 du compteur électrique 10, c'est-à-dire sur la face du boîtier 13 qui est visible et facilement accessible depuis l'extérieur.

L'accès aval 26 est ici protégé par un couvre-bornes aval positionné sur la face avant 17 du boîtier 13.

On voit plus précisément sur la figure 3 que, lorsque le compteur électrique 10 est vu en coupe selon un premier plan transversal perpendiculaire à la face arrière 18 et perpendiculaire à la hauteur du compteur électrique 10, les moyens de connexion amont 20 et les moyens de connexion aval 21 sont tous alignés selon un même premier axe X1 parallèle à la face arrière 18 du boîtier 13.

Les moyens de connexion aval 21, qui sont destinés à être reliés aux conducteurs aval 12 de l'installation, sont donc accessibles, via des connecteurs aval 27, depuis l'accès aval 26 de la face avant 18 du compteur électrique 10. Les moyens de connexion aval 21 restent donc facilement accessible pour le client après l'installation du compteur électrique 10 sur le mur : il suffit de retirer le couvre-bornes aval.

Par contre, les moyens de connexion amont 20 sont seulement accessibles, via des connecteurs amont 28, depuis l'accès amont 25 de la face arrière 18 du compteur électrique 10, et sont donc inaccessibles pour le client après l'installation du compteur électrique 10 : il n'est donc plus possible pour le client d'opérer sur la partie du compteur électrique 10 reliée au réseau de distribution.

Cette inaccessibilité limite la possibilité de réaliser une fraude en agissant sur les moyens de connexion amont 20 et/ou sur les conducteurs amont 11, puisqu'une telle fraude nécessite d'agir sur les moyens de fixation au mur du boîtier 13 de manière à démonter puis à éloigner le boîtier 13 du mur, avant de briser le dispositif de scellement du couvre-bornes amont positionné sur la face arrière 18 du boîtier 13.

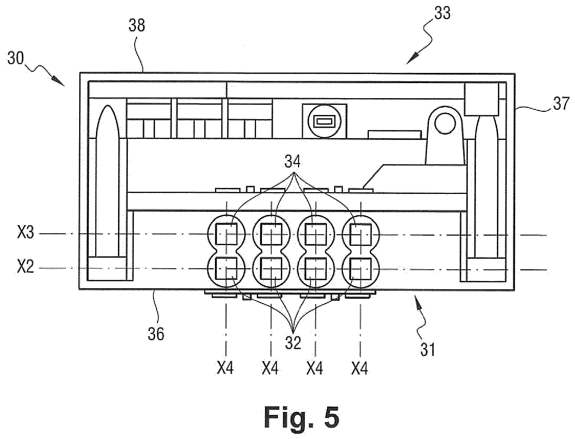

On décrit maintenant, en référence à la figure 5, un compteur électrique selon un deuxième mode de réalisation de l'invention 30.

Le compteur électrique 30 comporte à nouveau un accès amont 31 permettant d'accéder, depuis l'extérieur du compteur électrique 30, aux moyens de connexion amont 32, et un accès aval 33 permettant d'accéder, depuis l'extérieur du compteur électrique 30, aux moyens de connexion aval 34.

L'accès amont 31 est situé sur la face arrière 36 du boîtier 37 du compteur électrique 30, et est protégé par un couvre-bornes amont positionné sur la face arrière 36 du boîtier 37 et équipé d'un dispositif de scellement.

L'accès aval 33 est situé sur la face avant 38 du boîtier 37 du compteur électrique 30, et est protégé par un couvre-bornes aval positionné sur la face avant 38 du boîtier 37.

Lorsque le compteur électrique 30 est vu en coupe selon le premier plan transversal (qui est perpendiculaire à la face arrière 36 et perpendiculaire à une hauteur du compteur électrique 30), les moyens de connexion amont 32 sont alignés selon un même deuxième axe X2 parallèle à la face arrière 36 du boîtier 37. Les moyens de connexion aval 34 sont alignés selon un même troisième axe X3 parallèle à la face arrière 36 du boîtier 37. Le deuxième axe X2 est plus proche de la face arrière 36 que le troisième axe X3.

Pour chaque couple de moyens de connexion, le moyen de connexion amont 32 et le moyen de connexion aval 34 sont alignés selon un quatrième axe X4 perpendiculaire à la face arrière 36, le moyen de connexion amont 32 étant plus proche de la face arrière 36 que le moyen de connexion aval 34.

Effectivement, comme les moyens de connexion amont 32 sont accessibles depuis l'accès amont 31 situé sur la face arrière 36 et comme les moyens de connexion aval 34 sont accessibles depuis l'accès aval 33 situé sur la face avant 38, il n'est pas nécessaire de les aligner sur un même axe : les moyens de connexion amont 32 peuvent être plus proches de la face arrière 36 et les moyens de connexion aval 34 peuvent être plus proches de la face avant 38.

Cette disposition permet de pouvoir placer les cages à vis dans un arrangement différent afin de ne plus être contraint par les dimensions des étriers pour dimensionner le compteur électrique 30 en largeur. La largeur du compteur électrique 30 est ainsi réduite.

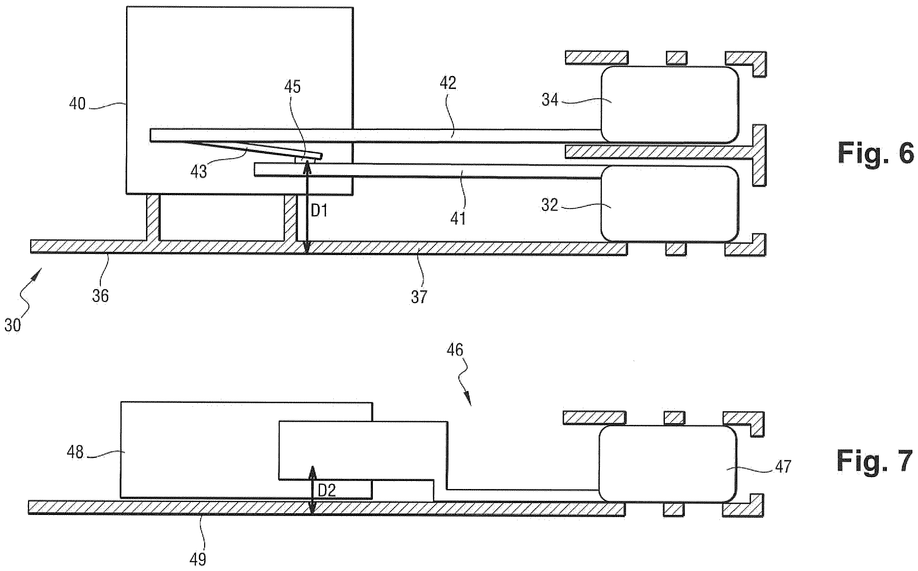

Cette disposition présente un avantage supplémentaire, qui est décrit en référence aux figures 6 et 7.

En référence à la figure 6, le compteur électrique selon le deuxième mode de réalisation de l'invention 30 comprend ici trois organes de coupures 40 (ou *breaker*) associés chacun à l'un des couples de moyens de connexion connectés aux conducteurs de phase amont et aux conducteurs de phase aval.

L'organe de coupure 40 de chaque couple de moyens de connexion est agencé pour sélectivement connecter ou déconnecter le moyen de connexion amont 32 et le moyen de connexion aval 34 dudit couple de moyens de connexion.

L'organe de coupure 40 peut donc être commandé pour relier entre eux le conducteur de phase amont et le conducteur de phase aval qui sont respectivement connectés au moyen de connexion amont 32 et au moyen de connexion aval 34 dudit couple de moyens de connexion, et donc pour permettre le passage de courant électrique sur le conducteur de phase amont et sur le conducteur de phase aval depuis le réseau de distribution vers l'installation. L'organe de coupure 40 peut aussi être commandé pour déconnecter le conducteur de phase amont du conducteur de phase aval et donc pour interrompre le passage du courant électrique sur le conducteur de phase amont et sur le conducteur de phase aval.

L'organe de coupure 40 comprend un bras amont 41 connecté au moyen de connexion amont 32, un bras aval 42 connecté au moyen de connexion aval 34, et un contact mobile 43 agencé pour connecter ou déconnecter électriquement le bras amont 41 et le bras aval 42.

Le bras amont 41 et le bras aval 42 s'étendent parallèlement à la face arrière 36 de sorte que, lorsque le compteur électrique 30 est vu en coupe selon un deuxième plan transversal perpendiculaire à la face arrière 36 et parallèle à une hauteur du compteur électrique (comme c'est le cas sur la figure 6), le bras amont 41 est situé au-dessous du bras aval 42, entre le bras aval 42 et la face arrière 36, et le contact mobile 43 s'étend entre le bras amont 41 et le bras aval 42.

On note aussi que, lorsque le compteur électrique 30 est vu en coupe selon le deuxième plan transversal, le bras amont 41 s'étend depuis une portion supérieure du moyen de connexion amont 32 (c'est-à-dire de la cage à vis) et le bras aval 42 s'étend depuis une portion inférieure du moyen de connexion aval 34 (c'est-à-dire de la cage à vis).

Dans cette configuration, le point chaud 45 de l'organe de coupure 40, qui est le point de contact entre le contact mobile 43 et le bras amont 41, est situé à une distance D1 importante de la face arrière 36. Ceci est très avantageux. Le boîtier 37 est en effet fabriqué en une matière plastique, et le point chaud 45 est susceptible d'être porté à une haute température. Une trop grande proximité entre la face arrière 36 et le point chaud 45 risque de dégrader la face arrière 36 ainsi que le fonctionnement du compteur électrique 30, voire même de provoquer un incendie.

En référence à la figure 7, on voit que, dans un compteur électrique 46 de l'art antérieur où tous les moyens de connexion 47 sont nécessairement alignés selon un même axe, le bras amont et le bras aval s'étendent non pas l'un au-dessus de l'autre mais l'un à côté de l'autre, et donc la distance D2 entre le point chaud de l'organe de coupure 48 et la face arrière 49 est moins importante que dans le compteur électrique selon l'invention 30. Le compteur électrique 30 est donc plus robuste que le compteur électrique 46.

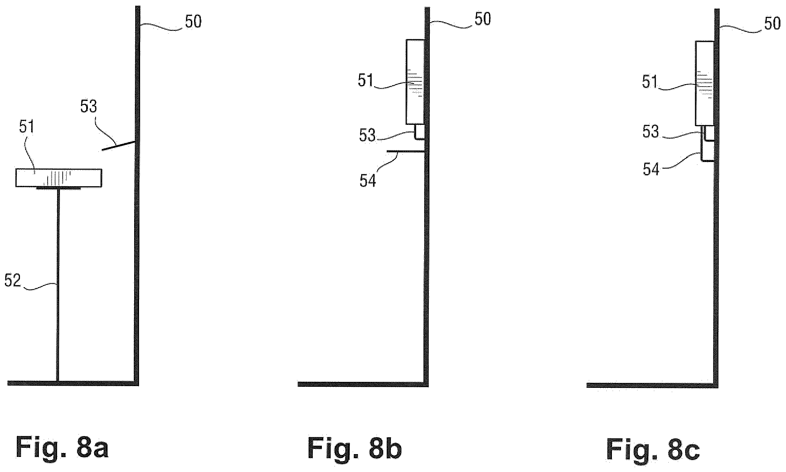

On décrit maintenant, en référence aux figures 8a à 8c, un premier procédé d'installation sur un mur 50 d'un compteur électrique selon l'invention 51.

En référence à la figure 8a, pour installer le compteur électrique 51, le technicien positionne tout d'abord le compteur électrique 51 sur un support mobile 52, et approche le support mobile 52 du mur 50. Le support mobile 52 est par exemple un escabeau, une chaise, ou bien un support dédié.

Puis, le technicien connecte les conducteurs amont 53 du réseau de distribution aux moyens de connexion amont du compteur électrique 51. Comme le compteur électrique 51 n'est pas encore monté sur le mur 50, l'accès amont, permettant d'accéder, depuis l'extérieur du compteur électrique 51, aux moyens de connexion amont, est accessible.

En référence à la figure 8b, le technicien fixe alors le compteur électrique 51 au mur 50. L'accès amont est désormais inaccessible car la face arrière du boîtier du compteur électrique 51 est positionnée contre le mur 50. Par contre, l'accès aval, situé sur la face avant du boîtier, est accessible.

En référence à la figure 8c, le technicien relie alors le client au réseau de distribution en connectant les conducteurs aval 54 de l'installation aux moyens de connexion aval du compteur électrique 51.

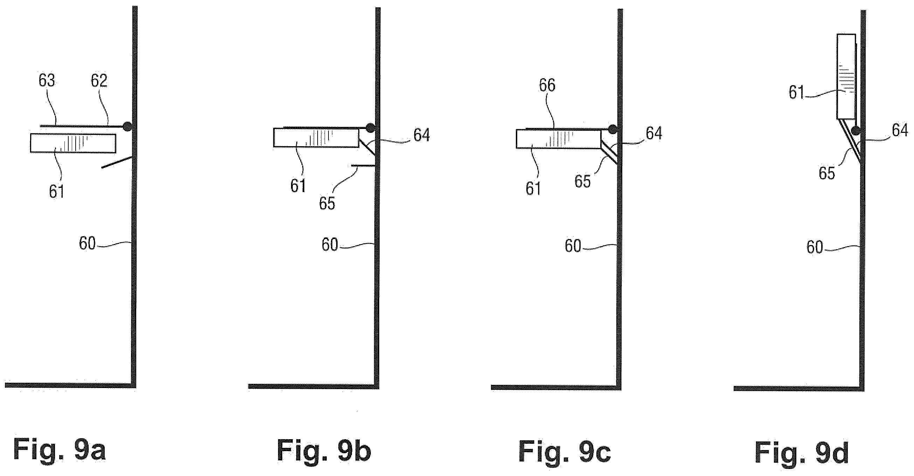

On décrit maintenant, en référence aux figures 9a à 9d, un deuxième procédé d'installation sur un mur 60 d'un compteur électrique selon l'invention 61.

En référence à la figure 9a, un support 62 est ici préalablement fixé sur le mur. Le support 62 a soit été prévu dès la construction du bâtiment comprenant le mur 60 et intégrant l'installation, soit est ajouté au moment de l'installation du compteur électrique 61.

Le support 62 comporte une charnière comprenant une lame fixe qui est fixée au support 62 et donc au mur 60, et une lame mobile 63.

Le technicien fixe le boîtier du compteur électrique 61, par vissage par exemple, à la lame mobile 63 de la charnière.

En référence aux figures 9b et 9c, le technicien oriente alors le compteur électrique 61 de manière à éloigner du mur 60 la face arrière 66 du compteur électrique 61. Ici, la face arrière 66 est positionnée perpendiculairement au mur 60, vers le haut et non vers le sol. Le technicien connecte alors les conducteurs amont 64 du réseau de distribution aux moyens de connexion amont du compteur électrique 61, et les conducteurs aval 65 de l'installation aux moyens de connexion aval du compteur électrique 61. Le technicien manipule le support si nécessaire.

En référence à la figure 9d, le technicien positionne alors la face arrière 66 du compteur électrique 61 contre le mur 60 et fixe la partie supérieure du boîtier au mur 60.

On note que le technicien peut aussi connecter les conducteurs aval 65 de l'installation aux moyens de connexion aval du compteur électrique 61 après avoir fixé la partie supérieure du boîtier au mur 60, puisque l'accès aval du compteur électrique 61 est situé sur la face avant et est accessible lorsque le compteur électrique 61 se trouve dans sa position normale de fonctionnement.

Bien entendu, l'invention n'est pas limitée aux modes de réalisation décrits mais englobe toute variante entrant dans le champ de l'invention telle que définie par les revendications.

Dans cette description, chaque compteur électrique selon l'invention comprend un boîtier dont la face arrière est positionnée contre un mur. La face arrière du boîtier pourrait, plus généralement, être positionnée contre tout support vertical : paroi de coffret, platine, etc.

On a décrit ici un compteur relié à une ligne triphasée comprenant un conducteur de neutre. Le compteur peut bien sûr être relié à une ligne monophasée, ou à une ligne multiphasée dont le nombre de phases est différent de trois. La ligne peut aussi ne pas comprendre de conducteur de neutre. Ainsi, par exemple, dans le cas où la ligne est une ligne monophasée sans conducteur de neutre, le compteur électrique comporte un seul couple de moyens de connexion relié à un seul couple de conducteurs comprenant un conducteur amont (qui est le conducteur de phase amont de la ligne monophasée du réseau de distribution) et un conducteur aval (qui est le conducteur de phase aval de l'installation), un seul organe de coupure, etc.

## Revendications

1. Compteur électrique agencé pour mesurer la consommation électrique d'une installation, le compteur électrique (10 ; 30 ; 51 ; 61) étant de plus agencé pour être connecté à au moins un couple de conducteurs comprenant un conducteur amont (11) appartenant à un réseau de distribution et un conducteur aval (12) appartenant à l'installation, le compteur électrique comportant :
- un boîtier (13 ; 37) agencé pour être fixé à un support vertical, le boîtier comprenant une face arrière (18 ; 36) destinée à être positionnée contre le support vertical ;
- des moyens de connexion intégrés à l'intérieur du boîtier et comprenant, pour chaque couple de conducteurs, un couple de moyens de connexion comprenant un moyen de connexion amont (20 ; 32) agencé pour être connecté au conducteur amont dudit couple de conducteurs, et un moyen de connexion aval (21 ; 34) agencé pour être connecté au conducteur aval dudit couple de conducteurs ;
- un accès amont (25 ; 31) permettant d'accéder, depuis l'extérieur du compteur électrique, aux moyens de connexion amont, l'accès amont étant situé sur la face arrière du boîtier,
**caractérisé en ce que** 1
le compteur électrique comprend en outre un accès aval (26) permettant d'accéder, depuis l'extérieur du compteur électrique, aux moyens de connexion aval, l'accès aval étant situé sur une face avant (17) du boîtier.

2. Compteur électrique selon la revendication 1, dans lequel, lorsque le compteur électrique (10) est vu en coupe selon un premier plan transversal perpendiculaire à la face arrière (18) et perpendiculaire à une hauteur du compteur électrique, les moyens de connexion amont (20) et les moyens de connexion aval (21) sont tous alignés selon un même premier axe (X1) parallèle à la face arrière du boîtier (13) .

3. Compteur électrique selon l'une des revendications précédentes, dans lequel, lorsque le compteur électrique (30) est vu en coupe selon un premier plan transversal perpendiculaire à la face arrière (36) et perpendiculaire à une hauteur du compteur électrique, les moyens de connexion amont (32) sont alignés selon un même deuxième axe (X2) parallèle à la face arrière du boîtier, les moyens de connexion aval (34) sont alignés selon un même troisième axe (X3) parallèle à la face arrière du boîtier, et, pour chaque couple de moyens de connexion, le moyen de connexion amont et le moyen de connexion aval sont alignés selon un quatrième axe (X4) perpendiculaire à la face arrière, le moyen de connexion amont (32) étant plus proche de la face arrière que le moyen de connexion aval (34).

4. Compteur électrique selon la revendication 3, comprenant au moins un organe de coupure (40) associé à un couple de moyens de connexion et agencé pour sélectivement connecter entre eux ou déconnecter le moyen de connexion amont (32) et le moyen de connexion aval (34) dudit couple de moyens de connexion, l'organe de coupure comprenant un bras amont (41) connecté au moyen de connexion amont, un bras aval (42) connecté au moyen de connexion aval, et un contact mobile (43) agencé pour connecter ou déconnecter électriquement le bras amont et le bras aval, le bras amont et le bras aval s'étendant parallèlement à la face arrière (36) de sorte que, lorsque le compteur électrique est vu en coupe selon un deuxième plan transversal perpendiculaire à la face arrière et parallèle à une hauteur du compteur électrique, le bras amont est situé au-dessous du bras aval, entre le bras aval et la face arrière, et le contact mobile s'étend entre le bas amont et le bras aval.

5. Compteur électrique selon la revendication 4, dans lequel, lorsque le compteur électrique est vu en coupe selon le deuxième plan transversal, le bras amont (41) s'étend depuis une portion supérieure du moyen de connexion amont (32) et le bras aval (42) s'étend depuis une portion inférieure du moyen de connexion aval (34).

6. Compteur électrique selon l'une des revendications précédentes, comprenant en outre un couvre-bornes amont positionné sur la face arrière du boîtier (13 ; 37) et agencé pour protéger l'accès amont.

7. Compteur électrique selon la revendication 6, le couvre-bornes amont étant équipé d'un dispositif de scellement.

8. Compteur électrique selon l'une des revendications précédentes, dans lequel chaque moyen de connexion amont et chaque moyen de connexion aval comprend une cage à vis comportant une vis de serrage.

9. Compteur électrique selon l'une des revendications précédentes, dans lequel le boîtier est agencé pour être fixé à une lame mobile (63) d'une charnière dont une lame fixe est fixée au support vertical.

10. Procédé d'installation sur un support vertical d'un compteur électrique selon l'une des revendications précédentes, comportant les étapes de :
- Positionner le compteur électrique (51) sur un support mobile (52), et approcher le support mobile du support vertical (50) ;
- Connecter le ou les conducteurs amont (53) du réseau de distribution aux moyens de connexion amont du compteur électrique ;
- Fixer le compteur électrique au support vertical ;
- Connecter le ou les conducteurs aval (54) de l'installation aux moyens de connexion aval du compteur électrique.

11. Procédé d'installation sur un support vertical d'un compteur électrique selon l'une des revendications 1 à 9, comportant les étapes de :
- Fixer le boîtier à une lame mobile (63) d'une charnière dont la lame fixe est fixée au support vertical (60) ;
- Orienter le compteur électrique (61) de manière à éloigner la face arrière du support vertical ;
- Connecter le ou les conducteurs amont (64) du réseau de distribution aux moyens de connexion amont du compteur électrique ;
- Connecter le ou les conducteurs aval (65) de l'installation aux moyens de connexion aval du compteur électrique ;
- Positionner la face arrière du compteur électrique contre le support vertical.

## Patentansprüche

1. Stromzähler, der dazu eingerichtet ist, den Stromverbrauch einer Anlage zu messen, wobei der Stromzähler (10; 30; 51; 61) ferner dazu eingerichtet ist, mit zumindest einem Leiterpaar verbunden zu werden, welches umfasst: einen vorgeordneten Leiter (11), der zu einem Verteilungsnetz gehört, und einen nachgeordneten Leiter (12), der zu der Anlage gehört, wobei der Stromzähler Folgendes enthält:
- ein Gehäuse (13; 37), das dazu eingerichtet ist, an einem vertikalen Träger befestigt zu werden, wobei das Gehäuse eine Rückseite (18; 36) zur Positionierung gegen den vertikalen Träger umfasst;
- in das Gehäuseinnere integrierte Verbindungsmittel die für jedes Leiterpaar ein Verbindungsmittelpaar umfassen, mit einem vorgeordneten Verbindungsmittel (20; 32), das dazu eingerichtet ist, mit dem vorgeordneten Leiter des Leiterpaars verbunden zu werden, und einem nachgeordneten Verbindungsmittel (21; 34), das dazu eingerichtet ist, mit dem nachgeordneten Leiter des Leiterpaars verbunden zu werden;
- einen vorgeordneten Zugang (25; 31), der von außerhalb des Stromzählers den Zugriff auf die vorgeordneten Verbindungsmittel ermöglicht, wobei sich der vorgeordnete Zugang an der Rückseite des Gehäuses befindet,
**dadurch gekennzeichnet, dass**
der Stromzähler ferner einen nachgeordneten Zugang (26) umfasst, der von außerhalb des Stromzählers den Zugriff auf die nachgeordneten Verbindungsmittel ermöglicht, wobei sich der nachgeordnete Zugang an einer Vorderseite (17) des Gehäuses befindet.

2. Stromzähler nach Anspruch 1, wobei in einer Schnittansicht des Stromzählers (10) gemäß einer ersten Querebene senkrecht zu der Rückseite (18) und senkrecht zu einer Höhe des Stromzählers die vorgeordneten Verbindungsmittel (20) und die nachgeordneten Verbindungsmittel (21) alle gemäß ein und derselben ersten Achse (X1) ausgerichtet sind, die parallel zur der Rückseite des Gehäuses (13) verläuft.

3. Stromzähler nach einem der vorhergehenden Ansprüche, wobei in einer Schnittansicht des Stromzählers (30) gemäß einer ersten Quer-ebene senkrecht zu der Rückseite (36) und senkrecht zu einer Höhe des Stromzählers die vorgeordneten Verbindungsmittel (32) gemäß ein und derselben zweiten Achse (X2) ausgerichtet sind, die parallel zu der Rückseite des Gehäuses verläuft, die nachgeordneten Verbindungsmittel (34) gemäß ein und derselben dritten Achse (X3) ausgerichtet sind, die parallel zur der Rückseite des Gehäuses verläuft, und für jedes Paar von Verbindungsmitteln, das vorgeordnete Verbindungsmittel und das nachgeordnete Verbindungsmittel gemäß einer vierten Achse (X4) ausgerichtet sind, die senkrecht zu der Rückseite verläuft, wobei das vorgeordnete Verbindungsmittel (32) näher an der Rückseite liegt als das nachgeordnete Verbindungsmittel (34).

4. Stromzähler nach Anspruch 3, umfassend zumindest ein Schaltorgan (40), das einem Paar von Verbindungsmitteln zugeordnet ist und dazu eingerichtet ist, das vorgeordnete Verbindungsmittel (32) und das nachgeordnete Verbindungsmittel (34) des Paars von Verbindungsmitteln selektiv miteinander zu verbinden oder voneinander zu trennen, wobei das Schaltorgan umfasst: einen vorgeordneten Arm (41), der mit dem vorgeordneten Verbindungsmittel verbunden ist, einen nachgeordneten Arm (42), der mit dem nachgeordneten Verbindungsmittel verbunden ist, und einen beweglichen Kontakt (43), der dazu eingerichtet ist, den vorgeordneten Arm und den nachgeordneten Arm elektrisch miteinander zu verbinden oder voneinander zu trennen, wobei der vorgeordnete Arm und der nachgeordnete Arm parallel zu der Rückseite (36) verlaufen, so dass in einer Schnittansicht des Stromzählers gemäß einer zweiten Querebene senkrecht zu der Rückseite und parallel zu einer Höhe des Stromzählers der vorgeordnete Arm unterhalb des nachgeordneten Arms zwischen dem nachgeordneten Arm und der Rückseite gelegen ist, und der bewegliche Kontakt sich zwischen dem vorgeordneten Arm und dem nachgeordneten Arm erstreckt.

5. Stromzähler nach Anspruch 4, wobei in einer Schnittansicht des Stromzählers gemäß der zweiten Querebene der vorgeordnete Arm (41) sich von einem oberen Abschnitt des vorgeordneten Verbindungsmittels (32) aus erstreckt, und der nachgeordnete Arm (42) sich von einem unteren Abschnitt des nachgeordneten Verbindungsmittels (34) aus erstreckt.

6. Stromzähler nach einem der vorhergehenden Ansprüche, ferner umfassend: eine vorgeordnete Klemmenabdeckung, die an der Rückseite des Gehäuses (13; 37) positioniert ist und dazu eingerichtet ist, den vorgeordneten Zugang zu schützen.

7. Stromzähler nach Anspruch 6, wobei die vorgeordnete Klemmenabdeckung mit einer Versiegelungseinrichtung versehen ist.

8. Stromzähler nach einem der vorhergehenden Ansprüche, wobei jedes vorgeordnete Verbindungsmittel und jedes nachgeordnete Verbindungsmittel eine Käfigmutter mit einer Spannschraube umfassen.

9. Stromzähler nach einem der vorhergehenden Ansprüche, wobei das Gehäuse dazu eingerichtet ist, an einem beweglichen Blatt (63) eines Scharniers fixiert zu werden, dessen festes Scharnierblatt an dem vertikalen Träger befestigt ist.

10. Verfahren zur Installation eines Stromzählers nach einem der vorhergehenden Ansprüche auf einem vertikalen Träger, umfassend die Schritte, dass:
- der Stromzähler (51) auf einem beweglichen Träger (52) positioniert wird und der bewegliche Träger an den vertikalen Träger (50) herangerückt wird;
- der oder die vorgeordneten Leiter (53) des Verteilungsnetzes mit den vorgeordneten Verbindungsmitteln des Stromzählers verbunden werden;
- der Stromzähler an dem vertikalen Träger befestigt wird;
- der oder die nachgeordneten Leiter (54) der Anlage mit den nachgeordneten Verbindungsmitteln des Stromzählers verbunden werden.

11. Verfahren zur Installation eines Stromzählers nach einem der Ansprüche 1 bis 9 auf einem vertikalen Träger, umfassend die Schritte, dass:
- das Gehäuse an einem beweglichen Blatt (63) eines Scharniers fixiert wird, dessen festes Blatt an dem vertikalen Träger (60) befestigt ist;
- der Stromzähler (61) derart ausgerichtet wird, dass die Rückseite von dem vertikalen Träger entfernt gelegen ist;
- der oder die vorgeordneten Leiter (64) des Verteilungsnetzes mit den vorgeordneten Verbindungsmitteln des Stromzählers verbunden werden;
- der oder die nachgeordneten Leiter (65) der Anlage mit den nachgeordneten Verbindungsmitteln des Stromzählers verbunden werden;
- die Rückseite des Stromzählers gegen den vertikalen Träger positioniert wird.

## Claims

1. An electricity meter arranged to measure the electricity consumption of an installation, the electricity meter (10; 30; 51; 61) also being arranged to be connected to at least one pair of conductors comprising an upstream conductor (11) belonging to a distribution network and a downstream conductor (12) belonging to the installation, the electricity meter comprising:
· a housing (13; 37) arranged to be fastened to a vertical support, the housing having a rear face (18; 36) for positioning against the vertical support;
· connection means integrated inside the housing and comprising, for each pair of conductors, a pair of connection means comprising upstream connection means (20; 32) arranged to be connected to the upstream conductor of said pair of conductors, and downstream connection means (21; 34) arranged to be connected to the downstream conductor of said pair of conductors;
· an upstream access (25; 31) giving access, from outside the electricity meter, to the upstream connection means, the upstream access being situated in the rear face of the housing,
**characterized in that** the electricity meter further comprises a downstream access (26) giving access, from outside the electricity meter, to the downstream connection means, the downstream access being situated in a front face (17) of the housing.

2. An electricity meter according to claim 1, wherein when the electricity meter (10) is seen in cross-section on a first plane perpendicular to the rear face (18) and perpendicular to a height of the electricity meter, the upstream connection means (20) and the downstream connection means (21) are all aligned along a common first axis (X1) parallel to the rear face of the housing (13) .

3. An electricity meter according to any preceding claim, wherein when the electricity meter (30) is seen in cross-section on a first plane perpendicular to the rear face (36) and perpendicular to a height of the electricity meter, the upstream connection means (32) are aligned along a common second axis (X2) parallel to the rear face of the housing, the downstream connection means (34) are aligned along a common third axis (X3) parallel to the rear face of the housing, and for each pair of connection means, the upstream connection means and the downstream connection means are in alignment along a respective fourth axis (X4) perpendicular to the rear face, the upstream connection means (32) being closer to the rear face than the downstream connection means (34).

4. An electricity meter according to claim 3, including at least one cut-off member (40) associated with a pair of connection means and arranged act selectively to connect together or to disconnect the upstream connection means (32) and the downstream connection means (34) of said pair of connection means, the cut-off member comprising an upstream arm (41) connected to the upstream connection means, a downstream arm (42) connected to the downstream connection means, and a movable contact (43) arranged to connect or disconnect the upstream arm and the downstream arm electrically, the upstream arm and the downstream arm extending parallel to the rear face (36) in such a manner that, when the electricity meter is seen in cross-section on a second plane perpendicular to the rear face and parallel to a height of the electricity meter, the upstream arm is situated below the downstream arm, between the downstream arm and the rear face, and the movable contact extends between the upstream arm and the downstream arm.

5. An electricity meter according to claim 4, wherein when the electricity meter is seen in cross-section on the second plane, the upstream arm (41) extends from a top portion of the upstream connection means (32) and the downstream arm (42) extends from a bottom portion of the downstream connection means (34).

6. An electricity meter according to any preceding claim, further comprising an upstream terminal cover positioned on the rear face of the housing (13; 37) and arranged to protect the upstream access.

7. An electricity meter according to claim 6, the terminal cover being fitted with a sealing device.

8. An electricity meter according to any preceding claim, wherein each upstream connection means and each downstream connection means comprises a screw cage including a clamping screw.

9. An electricity meter according to any preceding claim, wherein the housing is arranged to be fastened to a movable leaf (63) of a hinge having a stationary leaf that is fastened to the vertical support.

10. An installation method for installing an electricity meter according to any preceding claim on a vertical support, the method comprising the steps of:
· positioning the electricity meter (51) on a movable support (52) and moving the movable support close to the vertical support (50);
· connecting the upstream conductor(s) (53) of the distribution network to the upstream connection means of the electricity meter;
· fastening the electricity meter to the vertical support;
· connecting the downstream conductor(s) (54) of the installation to the downstream connection means of the electricity meter.

11. An installation method for installing an electricity meter according to any one of claims 1 to 9 on a vertical support, the method comprising the steps of:
· fastening the housing to the movable leaf (63) of a hinge having its stationary leaf fastened to the vertical support (60)
· swiveling the electricity meter (61) so as to move its rear face away from the vertical support;
· connecting the upstream conductor(s) (64) of the distribution network to the upstream connection means of the electricity meter;
· connecting the downstream conductor(s) (65) of the installation to the downstream connection means of the electricity meter;
· positioning the rear face of the electricity meter against the vertical support.
